# EUROPEAN PATENT SPECIFICATION

(11) **EP 0 425 778 B1**
(45) Date of publication and mention of the grant of the patent: **11.12.1996**
(21) Application number: 90115590.3
(22) Date of filing: 14.08.1990
(51) Int. Cl.: H05K 7/14

(54) **Subrack for telecommunication equipments**
Baugruppenträger für eine Vermittlungsanlage
Rack pour des équipements de télécommunications

(30) Priority: 31.10.1989 IT 2223289
(43) Date of publication of application: 08.05.1991
(73) Proprietor: Alcatel Italia S.p.A, 20158 Milano (IT)
(72) Inventor: Zingrini, Carlo, I-20059 Vimercate (MI) (IT); Oreglio, Maurizio, I-20060 Bellinzago Lombardo (MI) (IT); Ronchi, Domenico, I-20040 Cambiago (MI) (IT)
(74) Representative: Strehl Schübel-Hopf Groening & Partner

(56) References cited:
- EP-A- 0 068 849
- EP-A- 0 105 150
- EP-A- 0 217 162
- DE-A- 3 110 717
- DE-A- 3 209 205

## Description

The present invention refers to a subrack for housing electronic circuits, in particular in the form of cards or printed circuit boards (PCS) for telecommunication equipments, formed by four crosspieces supplied with means offset by a certain pitch along the axis of each crosspiece, for being engaged with corresponding insertion means provided on the bottom of boardguides, each crosspiece being provided with grooves for being fixed to the sides and with a groove for snap insertion with said boardguides.

The importance of subracks in telecommunication systems is well-known; they must include the maximum number of printed circuit boards in the least possible volume, respecting the international standards such as DIN 41494-IEC 297.

Further, there is a continuous tendency to miniaturize the electronic circuits, that may be at least partially impeded by the lack of timely and suitable modifications of the mechanical structures to house them.

In practice, subracks are made up of four crosspieces that are redundantly provided with drillings.

A second drawback is added to this first drawback, arising from the fact that the pitch of the drillings is 5.08 mm, consequently the minimum pitch (Pmin) of the housing of printed circuits is made, according to standard DIN 41494-IEC 297, as a multiple of 5.08 mm (1/5 inch).

This pitch Pmin is too restrictive for telecommunication equipment (in which there is a continuous development) as it offers only the possibility of making unit dimensions that are multiples of 5.08 mm (e.g. 20.32 mm, 25.4 mm, 30.48 mm, etc.).

DE-A-3 110 719 discloses a subrack which has the features recited in the first part of claim 1. The known subrack employs toothed detent bars inserted in grooves of subrack crosspieces, to avoid the necessity of providing holes in the crosspieces. The teeth are arranged with the conventional pitch.

It is an object of the present invention to provide a subrack which allows optimum use of the space available for arranging printed circuit boards, yet taking account of existing standards. This object is met by the subrack defined in claim 1. Due to the fact that the seats provided on the boardguides for engagement by the teeth are offset from the centre of the boardguides, rotating anyone of the adjacent boardguides by 180° will provide a variety of positions of the individual circuit boards on the subrack and a variety of spacings between adjacent circuit boards. Preferred embodiments of the invention are set forth in the dependent claims.

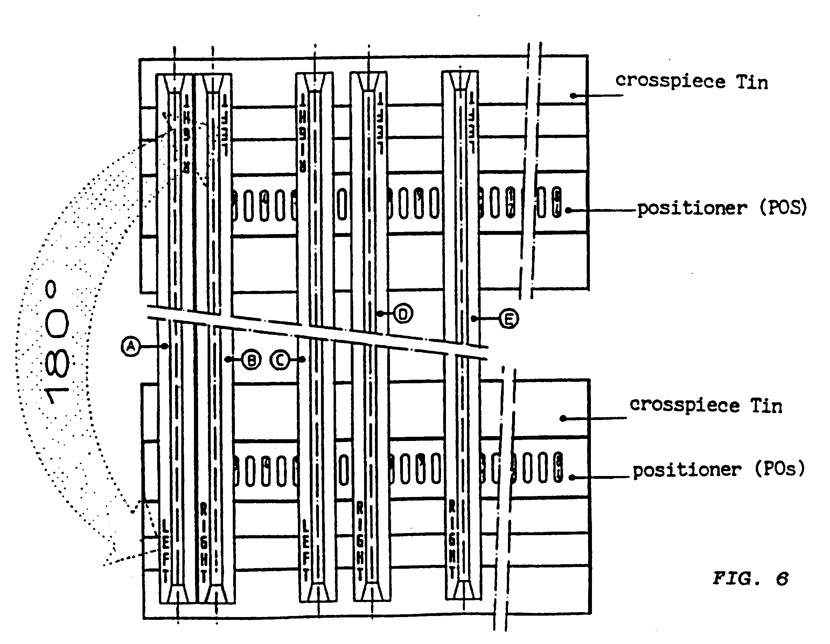

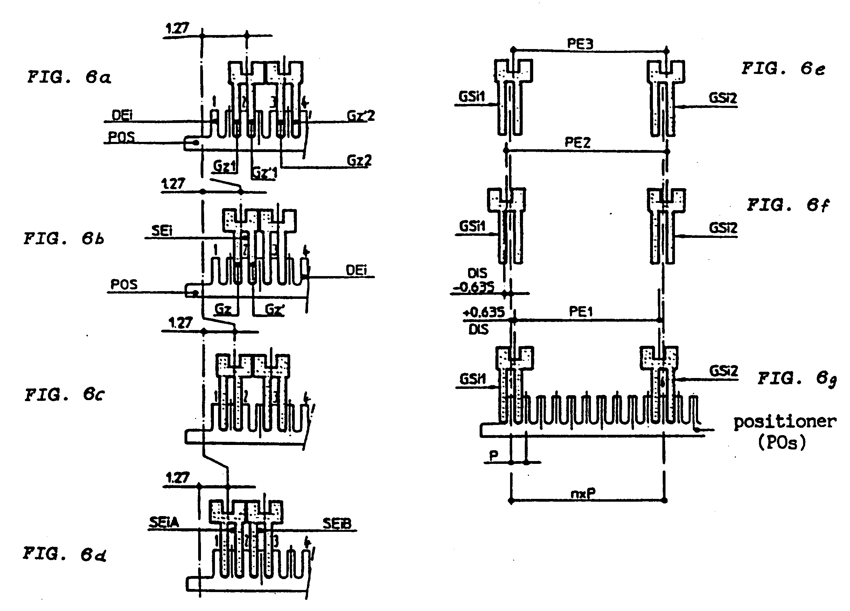

The invention will now be explained in more detail with respect to the drawings, in which
- Figures 1 and 2 are partial perspective views of a single crosspiece and, respectively, a partial subrack arrangement in accordance with the prior art,
- Figures 3 and 4 are views similar to Figure 1 of a crosspiece of a subrack according to the invention;
- Figure 5 is a schematic exploded perspective view of a base of the subrack according to the invention with five boardguides designed from A to E;
- Figures from 6a and 6h are partial section views of the different possible eccentricities or misalignments of the seats (SEi) of the boardguides and different possible couplings and real pitches with the teeth of a positioner according to the invention, the Figure 6i being on the contrary a similar schematic section of a crosspiece of the prior art,

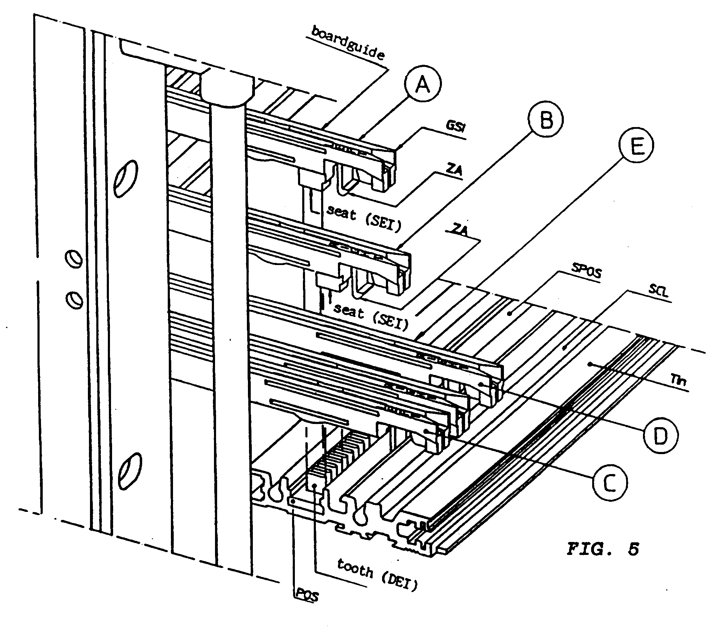

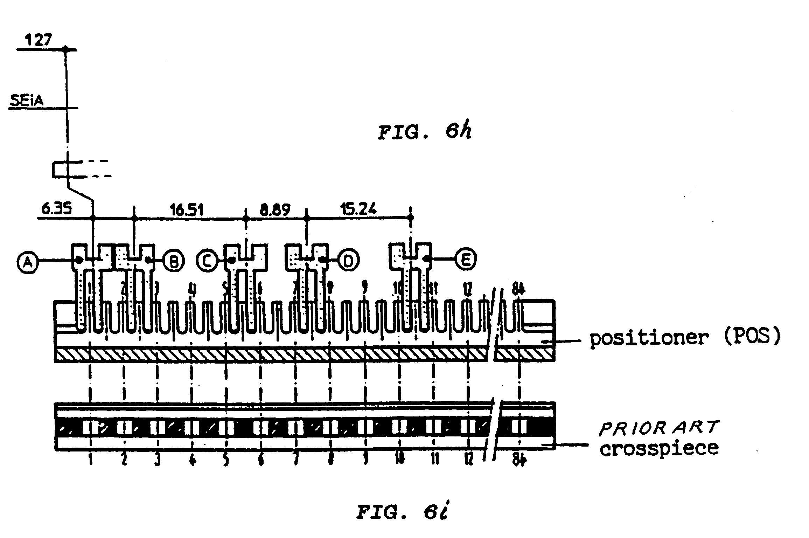

- Figure 6 is a schematic plan view of the Figures 5 and 6i;

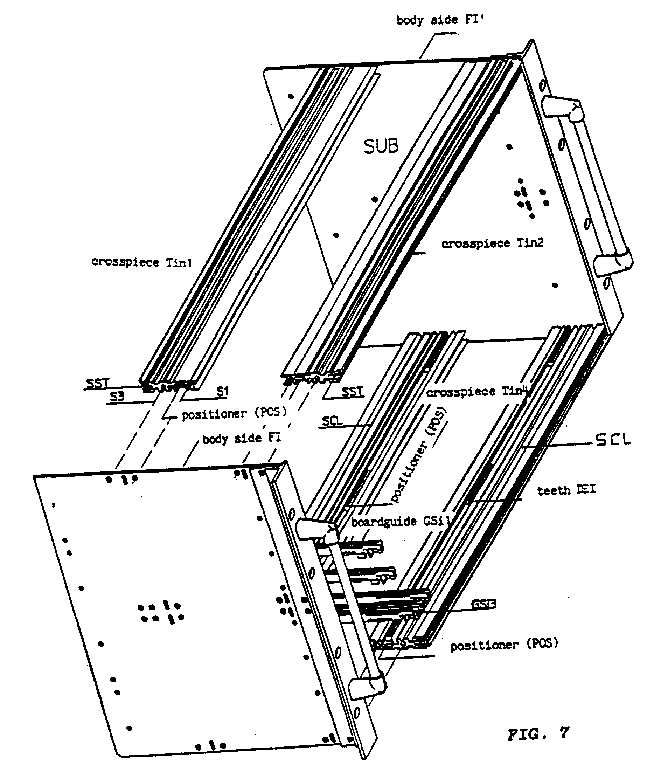

- Figure 7 is a schematic exploded perspective view of a subrack completed according to the invention;

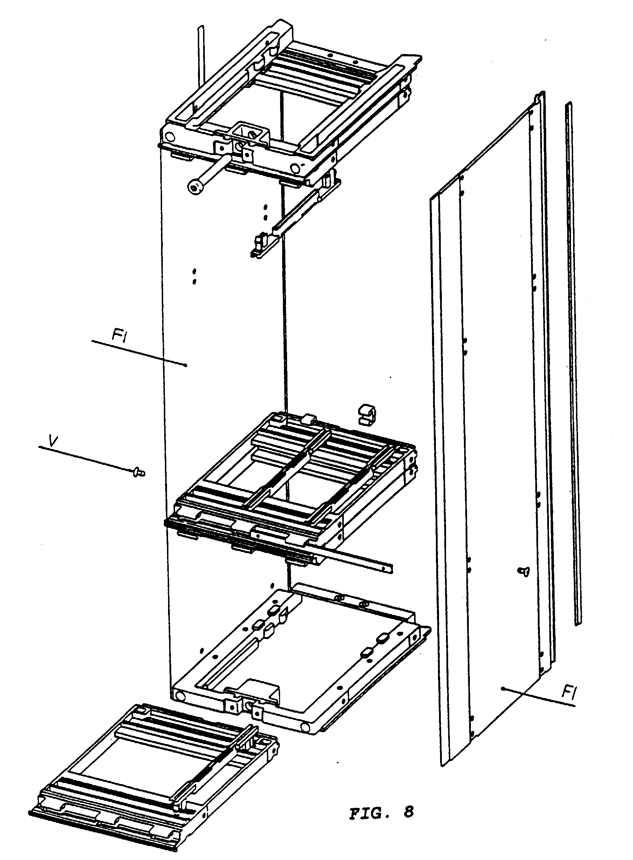

- Figure 8 is an exploded perspective view of a subrack according to another embodiment of the invention and related upright of the frame;

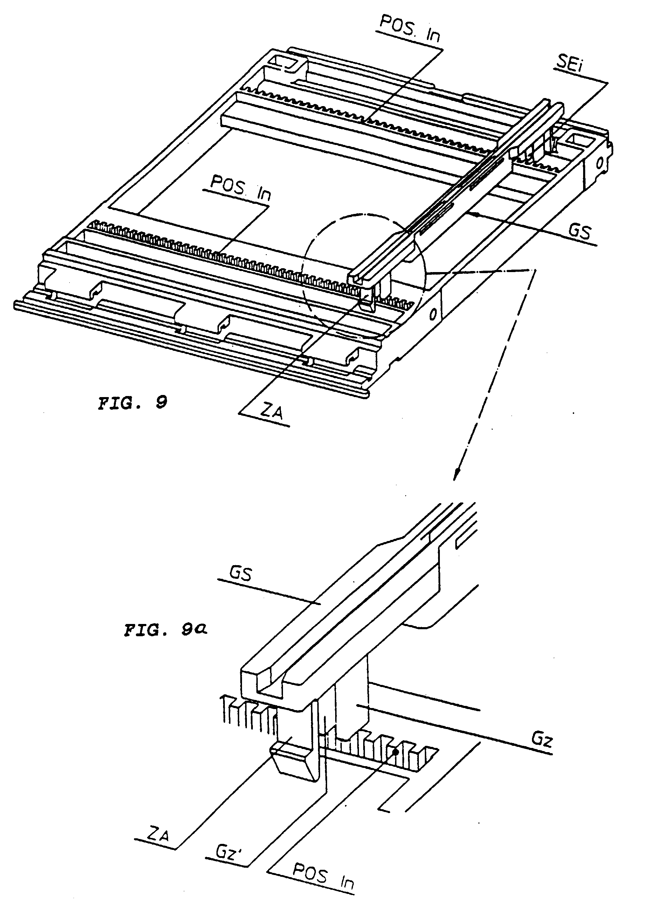

- Figures 9 and 9a are schematic exploded perspective views of an embodiment of the invention with positioners formed directly on the crosspiece; and

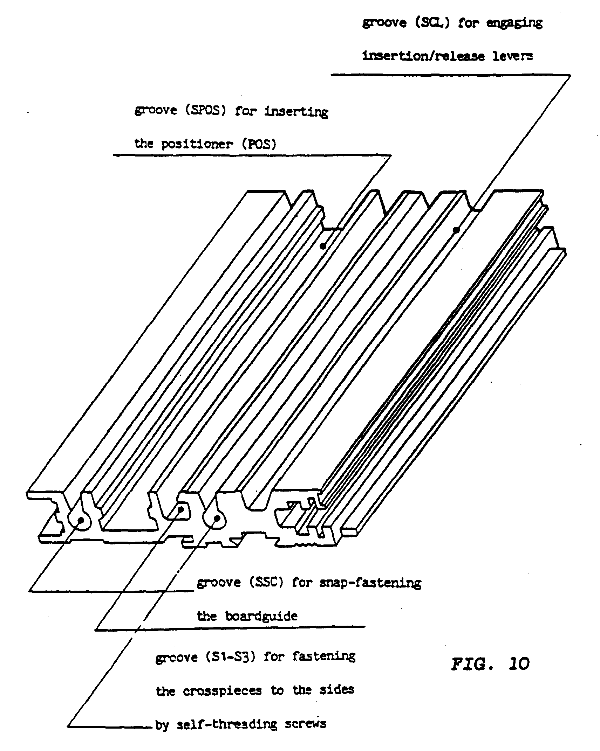

- Figure 10 is a perspective view in enlarged scale of a crosspiece according to the invention, that shows better the different grooves, the positioner being removed.

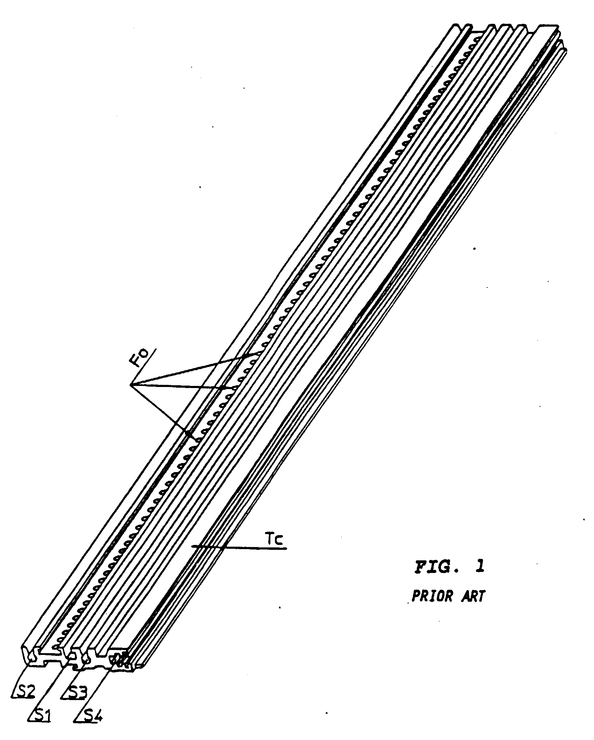

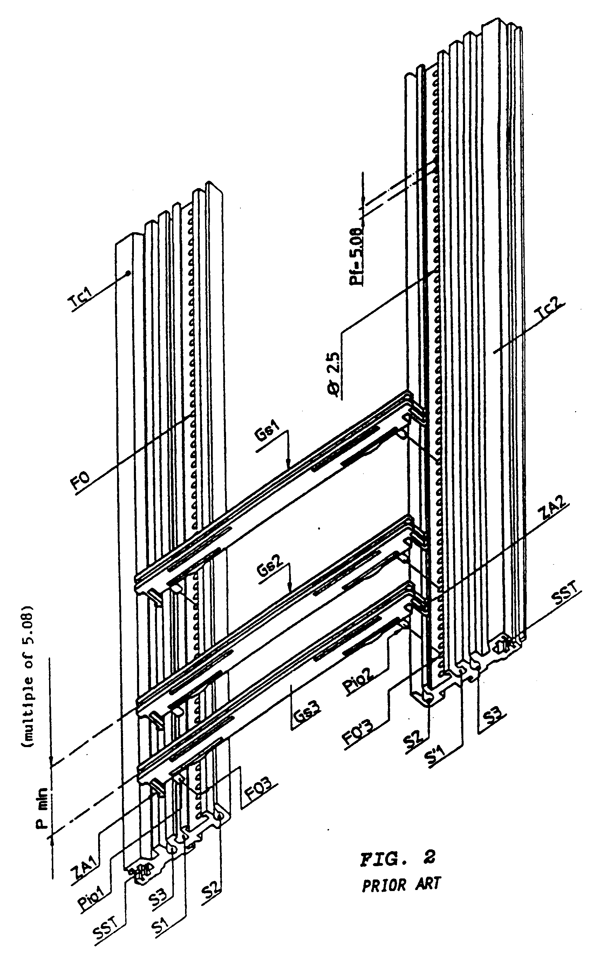

The Figure 1 shows a conventional crosspiece Tc having a long series of holes FO and four grooves S1, S2, S3, S4; the preparation of this crosspiece requires machining of a certain complexity. As can be seen from Figure 2, two cross-pieces Tc1 and Tc2, each one having holes FO at a pitch of 5.08 mm, (1/5 inch) receive the boardguides GS1, GS2, GS3, each of which has two pins Pio1, Pio2 to be engaged into the aligned holes FO3, FO'3 and two legs ZA1, ZA2 to be snap-engaged into the related grooves S1-S'1.

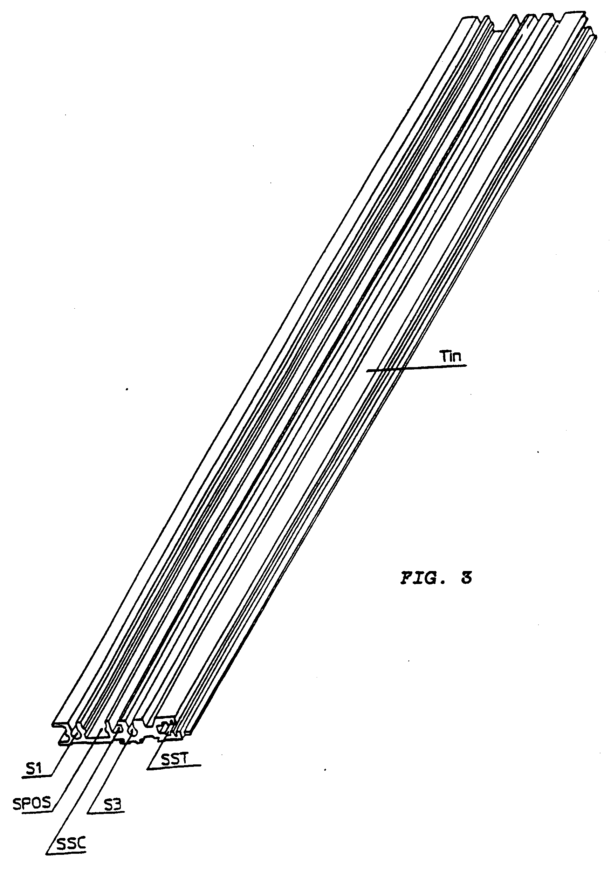

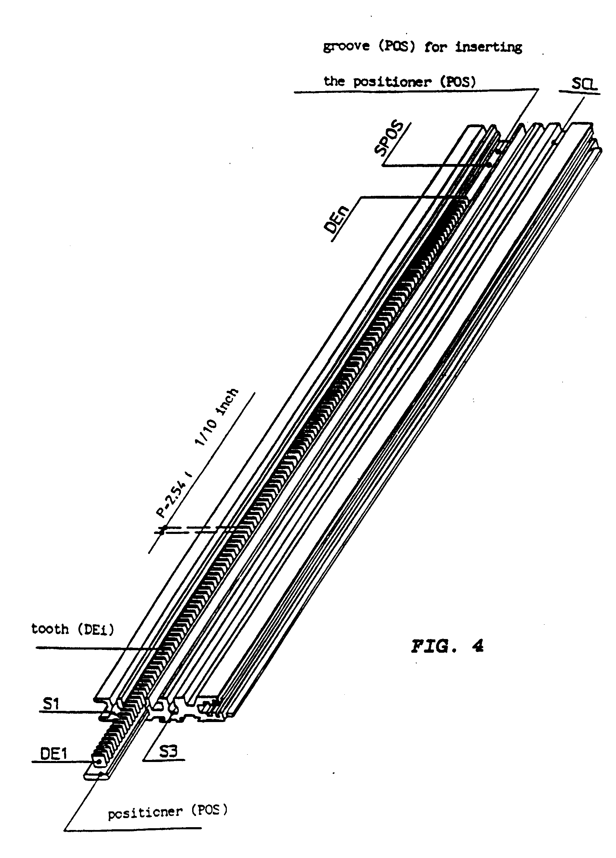

Owing to its difficult machining the holes must have a minimum suitable diameter. e.g. of 2.5 mm, its minimum pitch (Pf) according to DIN 41494 IEC 297 was 5.08 mm (1/5 inch), therefore the housing pitch Pmin (distance between two adjacent printed circuits) was necessarily a multiple of Pf. According to the invention (Figures 3 and 4) the new crosspiece Tin no longer has drillings, but has two grooves S1 and S3 for fastening the same crosspiece to the body side F1 of the subrack, a groove SSC for snap-fastening the boardguide GSi, and a groove SPOS that houses or receives a positioner POS having a series of teeth DE1 and DEn forming a rack (Figures 4 and 5). In the Figures, SST indicates the conventional groove for inserting threaded bars normally used for fastening front plates, connector-holder brackets, rear parts (back panels), etc..

As Figure shows, the pitch between the teeth is e.g. P= 2.54 mm (that is 1/10 inch).

The minimum pitch P'min now becomes a quarter of the minimum conventional pitch P'min = Pmin/4 = 5.08/4 = 1.27 that is 1/20 inch. This is very advantageous as it allows to obtain a dimension of unit housing which is a multiple of 1.27 mm (e.g. 20.32 mm, 21.59mm, 22.86mm; 24.13mm; 25.4mm), thus permitting optimal use of the available space for the printed circuits without violating the standard DIN 41494 IEC 297.

In a first embodiment, the toothed positioner POS is constituted by a part that is formed separately and is then inserted into the groove SPOS.

Preferably the positioner POS is molded from plastics material.

In another embodiment, the positioner POS is directly provided on the crosspiece and/or formed integrally therewith, e.g. with the groove SPOS.

The tooth DEi of the positioner POS is received by a seat SEi (Figure 5) machined in the boardguide GSi. As can be seen in better detail in the Figures 6-6h, the seats SEI have a fork form with two protruding legs Gz-Gz' suitable for being placed onto a tooth DEi of the positioner (POS). The seats SEi have critically an eccentricity or misalignment DIS that, in the most preferred embodiment, is equal to a fourth of the tooth pitch P, that is DIS = P/4 = 2.54mm: 4 = 0.635 mm (that is 1/40 inch).

Turning to the boardguide by 180°, the misalignment (DIS) can be made positive (+0.635) or negative (-0.635) with respect to the axis of the positioner tooth, so that the following actual housing pitches (PE) may be obtained:$\text{PE1= (n x P) - (2 x DIS) = (10 x 2.54mm) - (2 x 0.635mm) = 24.13mm}$$\text{PE2= (n x P) - (2 x DIS) = (10 x 2.54mm) - (2 x 0.635mm) = 26.67mm}$$\text{PE3= (n x P) - DIS+DIS = (10 x 2.54mm)- 0.635mm+0.635mm= 25.4mm}$ (with n being equal to 10).

The Figure 5 shows in perspective view a crosspiece Tin with a positioner indicated by POS, that receives five boardguides A, B, C, D, E.

Figure 6 shows that the boardguides A and B just as C and D are turned with respect to one another, while the boardguide E is not turned with respect to D or with respect to B.

Figures from 6a to 6h show respectively:

Figures 6 and 6h are front views of the boardguides A, B, C, D, E in different possible assembly positions/ rotations.

Figures 6a, 6b, 6c and 6d show respectively the change of the pitch by progressive increments e.g. of 1.27 (equal to 1/20 inch) passing in increasing order from one figure to the next. Starting from the position of Figure 6d, the position of Figure 6c is obtained by rotation by 180° of SEiA and SEiB, keeping constant the tooth (DEi) engaged between 1 and 2.

The position of Figure 6b is obtained from the position of Figure 6d without rotation, but inserting the teeth 2 and 3 with one another.

Figure 6a is similar to the Figure 6b, but showing further the rotation of the boardguides by 180°.

Figures 6e, 6f and 6g represent respectively the real pitches PE1, PE2 and PE3 where. considering e.g. PE1 as start pitch. PE2 is obtained by turning Gsi1 by 180° and engaging the seat of the same boardguide always onto the tooth 1 of the positioner and turning GSi2 by 180° and keeping always engaged the tooth of the positioner.

PE3 is obtained by turning GSi1 by 180° with respect to GSi1 of the Figure 6f keeping engaged the tooth 1 of the positioner and keeping GSi2 fixed with respect to the same GSi2.

The Figure 7 shows in perspective partial exploded view a subrack with four crosspieces Tin1, Tin2, Tin3, Tin4, each provided with a positioner (POS) and each being fixed to the body sides FI, FI' by self-threading screws V (Figure 8), that are engaged into the grooves S1 and S3; the crosspieces are of the type represented in enlarged scale in Figure 10, which shows an end groove SCL for engaging insertion levers and releasing the electronic devices in addition to a groove SSC for snap-engaging with legs ZA of the boardguides (GSi),

Figure 8 is a perspective exploded view of a subrack according to the second embodiment (Figure 9), where the positioner is formed integrally with the crosspiece; Figure 9a shows in enlarged scale the engagement of a boardguide GS with its seat SEi onto the teeth of the positioner POS.In.

## Claims

1. A subrack for housing electronic circuits, particularly in the form of cards or printed circuit boards for telecommunication equipment, formed by four crosspieces (Tin), each having a first groove (S1, S3) for connection to body sides (FI) of the subrack, a second groove (SSC) for snap-insertion of board guides (GSi), and a third groove (SPOS) including a positioner (POS) having teeth (DEi) projecting away from the bottom of the third groove (SPOS) for engaging corresponding seats (SEi) projecting from the bottom of the board guides (GSi),
**characterised** in that the seats (SEi) are disposed with a misalignment (DIS) with respect to the centre of the board guides (GSi).

2. The subrack of claim 1, wherein the misalignment (DIS) is equal to one-fourth the pitch (P) of the positioner teeth (DEi).

3. The subrack of claim 1 or 2, wherein the pitch (P) of the positioner teeth (DEi) is one-half the standard pitch (Pmin) according to DIN 41494 IEC 297.

4. The subrack of claim 1 or 2, wherein the pitch (P) of the positioner teeth is 2.54 mm and said misalignment (DIS) is 0.635 mm.

5. The subrack of any preceding claim, wherein the positioner (POS) is a preformed piece, preferably made of plastics material, inserted into said third groove (SPOS).

6. The subrack of any of claims 1 to 4, wherein the positioner (POS) is formed integrally with said third groove (SPOS).

7. The subrack of any preceding claim, wherein the seats (SEi) to be engaged by the positioner teeth (DEi) are formed at least by two lateral walls (Gz) spaced apart in accordance with the tooth thickness.

## Patentansprüche

1. Baugruppenträger zum Unterbringen von elektronischen Schaltungen, insbesondere in Form von Karten oder gedruckten Schaltungstafeln für Vermittlungsanlagen, gebildet aus vier Querträgern (Tin), deren jeder eine erste Nut (S1, S3) zur Verbindung mit Gehäuseseiten (FI) des Baugruppenträgers, eine zweite Nut (SSC) zum Einschnappen von Tafelführungen (GSi) und eine dritte Nut (SPOS) mit einem Positionierelement (POS) aufweist, das vom Boden der dritten Nut (SPOS) herausragende Zähne (DEi) zum Eingriff in entsprechende, vom Boden der Tafelführungen (GSi) herausragende Aufnahmen (SEi) aufweist,
dadurch **gekennzeichnet**, daß die Aufnahmen (SEi) mit einer Fehlausrichtung (DIS) bezüglich der Mitten der Tafelführungen (GSi) angeordnet sind.

2. Baugruppenträger nach Anspruch 1, wobei die Fehlausrichtung (DIS) ein Viertel der Teilung (P) der Positionierelement-Zähne (DEi) beträgt.

3. Baugruppenträger nach Anspruch 1 oder 2, wobei die Teilung (P) der Positionierelement-Zähne (DEi) die Hälfte der Normteilung (Pmin) gemäß DIN 41494 IEC 297 beträgt.

4. Baugruppenträger nach Anspruch 1 oder 2, wobei die Teilung (P) der Positionierelement-Zähne 2,54 mm und die Fehlausrichtung (DIS) 0,635 mm beträgt.

5. Baugruppenträger nach einem der vorhergehenden Ansprüche, wobei das Positionierelement (POS) ein in die dritte Nut (SPOS) eingeführtes vorgeformtes Bauteil, vorzugsweise aus Kunststoff, ist.

6. Baugruppenträger nach einem der Ansprüche 1 bis 4, wobei das Positionierelement (POS) mit der dritten Nut (SPOS) einstückig ist.

7. Baugruppenträger nach einem der vorhergehenden Ansprüche, wobei die Aufnahmen (SEi) für die Positionierelement-Zähne (DEi) von mindestens zwei Seitenwänden (Gz) gebildet sind, die in einem der Zahndicke entsprechenden Abstand voneinander angeordnet sind.

## Revendications

1. Tiroir pour recevoir des circuits électroniques, en particulier sous la forme de cartes ou de cartes à circuit imprimé, pour équipement de télécommunications, formé par quatre traverses (Tin), ayant chacune une première gorge (S1, S3) destinée à la connexion sur les côtés de corps (FI) du tiroir, une deuxième gorge (SSC) pour encliquetage de guides de carte (GSi), et une troisième gorge (SPOS) comportant un positionneur (POS) ayant des dents (DEi) faisant saillie en s'éloignant du fond de la troisième gorge (SPOS) pour venir en prise avec des sièges correspondants (SEi) faisant saillie à partir du fond des guides de cartes (GSi),
caractérisé en ce que les sièges (SEi) sont disposés en ayant un décalage (DIS) par rapport à l'axe des guides de cartes (GSi).

2. Tiroir selon la revendication 1, dans lequel le décalage (DIS) est égal à un quart du pas (P) des dents du positionneur (DEi).

3. Tiroir selon la revendication 1 ou 2, dans lequel le pas (P) des dents du positionneur (DEi) est la moitié du pas standard (Pmin) selon la norme DIN 41494 IEC 297.

4. Tiroir selon la revendication 1 ou 2, dans lequel le pas (P) des dents du positionneur est de 2,54 mm et ledit décalage (DIS) est de 0,635 mm.

5. Tiroir selon l'une quelconque des revendications précédentes, dans lequel le positionneur (POS) est une pièce préformée, constituée de préférence d'une matière plastique, insérée à l'intérieur de ladite troisième gorge (SPOS).

6. Tiroir selon l'une quelconque des revendications 1 à 4, dans lequel le positionneur (POS) est formé sous forme d'un tout avec ladite troisième gorge (SPOS).

7. Tiroir selon l'une quelconque des revendications précédentes, dans lequel les sièges (SEi) destinés à venir en prise avec les dents du positionneur (DEi) sont formés par au moins deux parois latérales (Gz) écartées conformément à l'épaisseur d'une dent.
